# EUROPÄISCHE PATENTSCHRIFT

(11) **EP 1 094 605 B1**
(45) Veröffentlichungstag und Bekanntmachung des Hinweises auf die Patenterteilung: **04.11.2009**
(21) Anmeldenummer: 00120514.5
(22) Anmeldetag: 20.09.2000
(51) Int. Cl.: H03K 17/16

(54) **Schaltungsanordnung zum Ansteuern einer Last mit reduzierter Störabstrahlung**
Circuit arrangement for controlling a load with reduced stray radiation
Montage servant à commander une charge à rayonnement parasite réduit

(30) Priorität: 22.09.1999 DE 19945432
(43) Veröffentlichungstag der Anmeldung: 25.04.2001
(73) Patentinhaber: Infineon Technologies AG, 81669 München (DE)
(72) Erfinder: Gergintschew, Zenko, 81379 München (DE)
(74) Vertreter: Patentanwälte Westphal, Mussgnug & Partner

(56) Entgegenhaltungen:
- EP-A- 0 688 077
- EP-A1- 0 570 584
- DE-A1- 4 207 187
- US-A- 5 398 318
- US-A- 5 483 188
- US-A- 5 838 186

## Beschreibung

Die Erfindung betrifft eine Schaltungsanordnung zum Ansteuern einer Last mit reduzierter Störabstrahlung mit einer Schaltvorrichtung, die seriell mit der Last zwischen zwei Versorgungspotentialan- schlüssen verschalten ist und mit einer Steuervorrichtung, die die Schaltvorrichtung ansteuert.

Derartige Schaltungsanordnungen werden häufig im pulsweitenmodulierten Betrieb angesteuert, um dadurch eine Stromregelung im Lastpfad zu erzielen. Der pulsförmige Stromverbrauch führt jedoch zu einer unerwünschten Störabstrahlung. Diese Störabstrahlungen können insbesondere benachbarte Schaltungsanordnungen in ihrer Funktion stören. Die Störabstrahlung (EMV-Störung) ist insbesondere angegeben, wenn die mit der Last seriell verschaltete Schaltvorrichtung komplett an- bzw. abgeschaltet wird. Die EMV-Störungen entstehen insbesondere durch diejenigen Bereiche der Stromverläufe, die eine besonders abrupte relative Abnahme oder Zunahme des Stromflusses aufweisen. Beim Einschalten ist die Stromzunahme von Null auf einen von Null verschiedenen Wert als besonders kritisch anzusehen. Die störende Strahlung würde dann vermieden, wenn der Stromverlauf einen sinusähnlichen Verlauf annimmt. Bei der Pulsweitenmodulation wird das Störspektrum durch die Form der Ein- und Abschaltflanken bestimmt. Das Maß der Störabstrahlung wird insbesondere durch die Flankensteilheit des Stromverlaufes bestimmt. Je flacher die Flankensteilheit ausfällt, desto geringer würde die Störabstrahlung werden. Eine flache Stromflanke hat jedoch den Nachteil, daß hierdurch die Schaltverluste drastisch erhöht werden. Zur Vermeidung von Schaltverlusten und somit einer thermischen Erwärmung des Halbleiterschalters ist es deshalb sinnvoll, die Stromflanke sowohl im Anstieg als auch während des Abfallens so steil wie möglich auszuführen. Andererseits erhöht sich hierdurch die elektromagnetische Störabstrahlung.

Werden als Halbleiterschalter MOS-Schalter verwendet, so sind insbesondere die unteren Ecken der Ein- und der Abschaltflanke bezüglich der Störstrahlung kritisch.

Es existiert deshalb das Bestreben, einen möglichst guten Kompromiß zwischen der Verlustleistung das Halbleiterschalters und der erzeugten Störstrahlung zu finden. In der nicht vorveröffentlichten deutschen Patentanmeldung 198 48 829.7 wird zur Lösung dieser Problematik vorgeschlagen, eine Steuerung bzw. Regelung der Gatespannung des Leistungstransistors vorzunehmen. Neben einer aufwendigen Steuerschaltung weist die dort vorgeschlagene Lösung den Nachteil auf, daß hierdurch nur die Abschaltflanke beeinflußt, daß heißt abgerundet wird. Für die Steuerschaltung ist zu dem ein hoher Schaltungsaufwand notwendig, der einerseits einen zusätzlichen Platzbedarf in einer integrierten Schaltungsanordnung benötigt und somit teuer ist und andererseits während der Einschaltflanke weiterhin EMV-Störungen verursacht.

Die EPA1-0 570 584 A1 beschreibt eine Sourcefolger-Schaltung, mit zwei Reihenschaltungen, welche parallel zueinander geschaltet sind.

Die US-A-5 398 318 beschreibt eine Schaltungsanordnung mit parallel geschalteten Transistoren, die unterschiedliche Schalteigenschaften besitzen und die durch separate Ansteuerschaltungen zeitlich versetzt angesteuert werden.

Die US-A-5 483 188 beschreibt eine Schaltungsanordnung mit mehreren parallel geschalteten MOSFET, die unterschiedlich groß sind und die zeitlich versetzt zueinander angesteuert werden.

Die DE-A1-42 07 187 beschreibt eine Schaltungsanordnung mit zwei parallel geschalteten IGBT, von denen einer durch eine Treiberschaltung direkt und von denen ein anderer über einen Vorwiderstand durch die Treiberschaltung angesteuert ist.

Die US-A-5 838 168 beschreibt eine Schaltungsanordnung mit mehreren parallel geschalteten MOSFET, denen ein Ansteuersignal über unterschiedlich große Vorwiderstände zugeführt ist.

Ausgehend von diesem Stand der Technik besteht die Aufgabe der vorliegenden Erfindung deshalb darin, eine Schaltungsanordnung zum Ansteuern einer Last vorzusehen, die eine wesentlich geringere Störabstrahlung verursacht.

Diese Aufgabe wird mit den Merkmalen des Patenanspruchs 1 gelöst.

Der Erfindung liegt die Erkenntnis zugrunde, daß die von einem Halbleiterschalter verursachte Störabstrahlung dadurch verringert werden kann, daß die Ein- und Abschaltflanken des Stromverlaufes abgerundet werden. Dies wird dadurch erreicht, daß die Schaltvorrichtung einen ersten und mindestens einen zweiten Halbleiterschalter aufweist, deren Laststrecken parallel geschalten sind und wobei die Einsatzspannung des er sten Halbleiterschalters größer als die des zweiten Halbleiterschalters ist. Die Einsatzspannungen der Halbleiterschalter können z. B. entweder durch unterschiedliche Dotierungen deren Bulk-Gebiete oder durch unterschiedliche Dicken deren Gateoxide festgelegt werden.

Beim Einschalten fängt deshalb der Halbleiterschalter mit der niedrigeren Einsatzspannung bereits bei kleineren Steuerspannungen durch die Steuervorrichtung an, Strom zu führen. Dies bedeutet, dieser Halbleiter leitet früher einen Strom. Wenig später schaltet auch der erste Halbleiterschalter mit der höheren Einsatzspannung ein. Entsprechend bleibt beim Abschalten der zweite Halbleiterschalter (mit der kleineren Einsatzspannung) länger leitfähig als der erste Halbleiterschalter. Durch die Überlagerung der Ströme des ersten und des zweiten Halbleiterschalters werden die unteren Ecken der Schaltflanken beim Ein- und Abschalten abgerundet. Hierdurch entstehen weniger Oberwellenkomponenten im Störspektrum.

In einer vorteilhaften Ausgestaltung sind die Steueranschlüsse des ersten und des zweiten Halbleiterschalters miteinander verbunden. Dies hat zufolge, daß alle drei Anschlüsse - Steueranschluß sowie die zwei Hauptanschlüsse - des ersten und des zweiten Halbleiterschalters miteinander verbunden sind. Die Ansteuerung der Schaltvorrichtung wird somit über eine einzige Leitung durch die Steuervorrichtung vorgenommen. Das unterschiedliche Schaltverhalten, daß heißt die Zeitpunkte des Ein- bzw. Ausschalten der jeweiligen Halbleiterschaltung ist somit ausschließlich durch die Einsatzspannungen des ersten und des zweiten Halbleiterschalters bestimmt.

Ferner ist es vorteilhaft, den ersten Halbleiterschalter mit einer größeren Zellenanzahl als den zweiten Halbleiterschalter auszustatten. Bevorzugt beträgt die Zellenanzahl des zweiten Halbleiterschalters zwischen zwei und fünf Prozent der Zellenanzahl des ersten Halbleiterschalters.

Alternativ weist der erste Halbleiterschalter ein wesentlich größeres W/L-Verhältnis auf als der zweite Halbleiterschalter. W repräsentiert hierbei die Kanalweite und L die Kanallänge eines feldeffektgesteuerten Bauelementes.

Die erfindungsgemäße Schaltungsanordnung kann entweder in monolithisch integrierter Weise ausgeführt werden oder aber aus diskreten Bauelementen bestehen. Der äußerst einfache Aufbau der Schaltungsanordnung eignet sich für diskret aufgebaute Halbleiterbauelemente, da diese in der Regel keine eigenen Logikschaltungen besitzen. Bisher war es zur Beeinflussung der Flankensteuerung deshalb notwendig, weitere externe Bauelemente vorzusehen, die beispielsweise die Gate Spannung in geeigneter Weise steuern oder regeln.

Die erfindungsgemäße Schaltungsanordnung zeichnet sich insbesondere dadurch aus, daß diese äußerst einfach aufgebaut ist und auf jegliche Arten einer Steuerung oder einer Regelung verzichten kann. Somit ist eine sehr kostengünstige Fertigung möglich, da bei einer integrierten Ausführung kein zusätzlicher Platz auf dem Halbleiterchip benötigt wird. In den meisten modernen integrierten Technologien stehen Zellen mit unterschiedlichen Einsatzspannungen zur Verfügung. Somit kann die Herstellung mit den bekannten Fertigungstechnologien ohne zusätzliche Fertigungsschritte oder Masken realisiert werden. Die Erfindung beeinflußt vorteilhafterweise gleichermaßen die Ein- und Abschaltflanke des Stromverlaufes. Sie ist sowohl in High-Side als auch in Low-Side-Konfigurationen anwendbar.

Die Erfindung und deren Vorteile werden anhand der nachfolgenden Figuren näher erläutert. Es zeigen:
Figur 1 ein Ausführungsbeispiel der erfindungsgemäßen Schaltungsanordnung in einer High-Side-Konfiguration,
Figur 2 einen beispielhaften Stromverlauf mit einer Ein- und einer Abschaltflanke und
Figur 3 ein weiteres Ausführungsbeispiel an der Erfindung in einer Low-Side-Konfiguration.

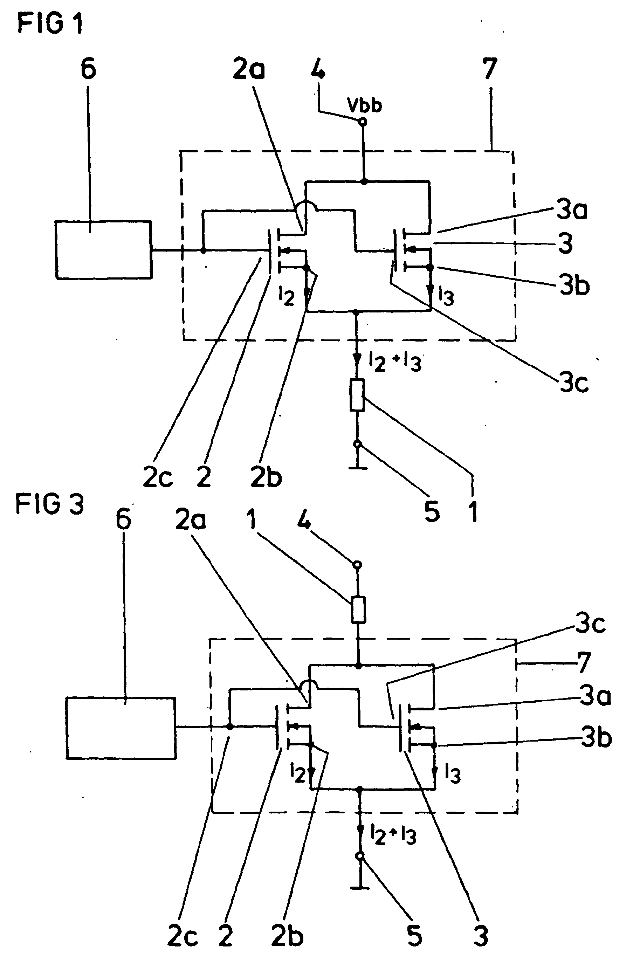

Figur 1 zeigt ein erstes Ausführungsbeispiel der erfindungsgemäßen Schaltungsanordnung. Zwischen einem ersten Versorgungspotentialanschluß 4 und einen zweiten Versorgungspotentialanschluß 5 ist die Reihenschaltung aus einer Schaltvorrichtung 7 und einer Last 1 verschalten. An dem ersten Versorgungspotentialanschluss 4 liegt ein hohes Versorgungspotential V_{bb} an, während am zweiten Versorgungspotentialanschluß 5 ein niedrigeres Versorgungspotential, zum Beispiel das Massepotential vorgesehen ist. Die Last 1 kann sowohl kapazitiver, induktiver, resistiver Art, als auch gemischter Art sein. Die Last könnte beispielsweise eine Lampe, ein Ventil oder einen Motor darstellen.

Die Schaltvorrichtung 7 weist zwei Halbleiterschalter 2,3 auf, die im vorliegenden Beispiel als MOSFETs ausgeführt sind. Die Laststrecken des ersten und des zweiten Halbleiterschalters 2,3 sind parallel geschalten. Drainseitig sind der erste und der zweite Halbleiterschalter 2,3 mit dem ersten Versorgungspotentialanschluß 4 verschalten. Die Sourceanschlüsse des ersten und des zweiten Halbleiterschalters 2,3 sind mit der Last 1 verbunden. Eine Steuervorrichtung 6, die nach Maßgabe eines zum Beispiel von außen herangeführten Signales die Halbleiterschalter leitend oder sperrend schaltet, ist mit den Gateanschlüssen der beiden Halbleiterschalter verbunden. Die Gateanschlüsse des ersten und des zweiten Halbleiterschalters 2,3 sind folglich miteinander verbunden. Die Ausgestaltung der Steuervorrichtung 6 für eine High-Side-Konfiguration ist aus dem Stand der Technik hinlänglich bekannt und nicht Gegenstand der vorliegenden Erfindung. Es wird deshalb auf eine genaue Beschreibung der Ausgestaltung an dieser Stelle verzichtet. Die Steuervorrichtung 6 könnte beispielsweise eine Ladungspumpenschaltung aufweisen.

Erfindungsgemäß weist der zweite Halbleiterschalter 3 eine geringere Einsatzspannung als der erste Halbleiterschalter 2 auf. Der zweite Halbleiterschalter 3 hat weiterhin eine geringere Zellenanzahl als der erste Halbleiterschalter 2 oder aber ein kleineres W/L- Verhältnis. W stellt dabei die Kanalweite dar, L die Kanallänge eines MOSFETs. Beim Erhalt eines Ansteuersignales durch die Steuervorrichtung 6 fängt der zweite Halbleiterschalter 3 mit der niedrigeren Schwellenspannung bereits bei kleineren Gatespannungen an Strom zu führen. Erreicht die Spannung am Gate der beiden Halbleiterschalter 2,3 die Einsatzspannung des ersten Halbleiterschalters 2, so liefert der zweite Halbleiterschalter 3 kurzzeitig einen größeren Strom, da die Drain-Source-Spannung während des Einschaltmomentes des ersten Halbleiterschalters kurzzeitig ansteigt. Gleiches gilt für den Moment des Ausschaltens, daß heißt während des Abfalls der Stromflanke des ersten Halbleiterschalters 2.

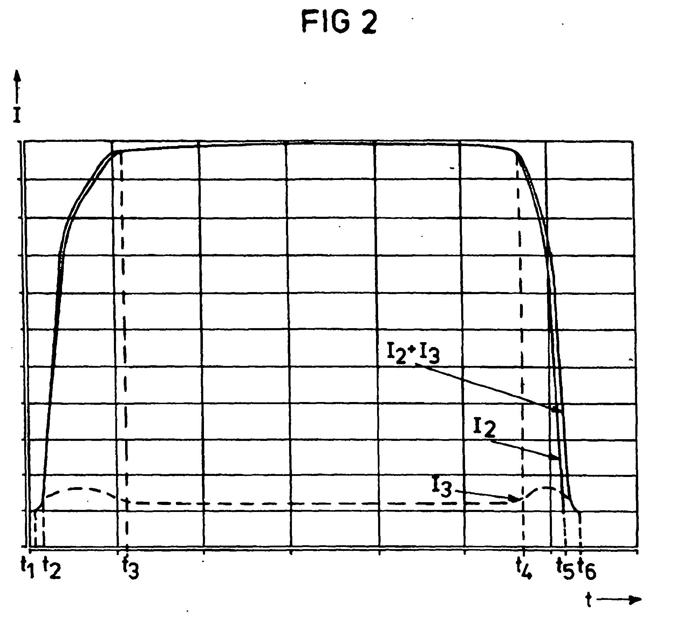

In Figur 2 ist der Stromverlauf durch den ersten und den zweiten Halbleiterschalter 2,3 während einer Ein- und einer Ausschaltflanke dargestellt. I₃ bezeichnet dabei den Strom durch den zweiten Halbleiterschalter 3, I₂ den Strom durch den ersten Halbleiterschalter 2. Die Summenfunktion der beiden Ströme ist mit I₂ + I₃ dargestellt. Zum Zeitpunkt t₁ wird durch die Steuervorrichtung 6 eine Gatespannung bereitgestellt, die der Einsatzspannung des zweiten Halbleiterschalters 3 entspricht. Dieser beginnt folglich zu leiten. Zum Zeitpunkt t₂ ist die Einsatzspannung des ersten Halbleiterschalters 2 erreicht. In der Zeitspanne zwischen t₂ und t₁ wird der Strom durch die Last im wesentlichen durch den zweiten Halbleiterschalter 3 bestimmt. Der Übergang vom nichtleitenden in den leitenden Zustand ist in diesem Zeitraum durch eine relativ flache Stromanstiegsflanke bestimmt.

Ab dem Zeitpunkt t₂ beginnt der erste Halbleiterschalter 2 zu leiten. Dieser ist in der Lage, ein Vielfaches des Stromes des zweiten Halbleiterschalters 3 zu tragen. Hierdurch ergibt sich eine sehr hohe Stromanstiegsgeschwindigkeit. Bis zum Zeitpunkt t₃ ist der erste Halbleiterschalter 2 vollkommen aufgesteuert, daß heißt vollständig leitend. Während des Einschaltvorganges des ersten Halbleiterschalters 2, daß heißt in der Zeitspanne zwischen t₃ und t₂ steigt die Drain-Source Spannung stark an. Dies bedingt im zweiten Halbleiterschalter 3 aufgrund der physikalischen Zusammenhänge einen größeren Stromfluß durch die Last. Diese macht sich zwar in der Summe nicht stark bemerkbar, er ist jedoch für die "Verrundung" der Einschaltflanke zwischen t₁ und t₂ verantwortlich.

Im Abschaltvorgang laufen die Vorgänge in umgekehrter Weise ab. Zum Zeitpunkt t₄ ist die Einsatzspannung des ersten Halbleiterschalters 2 erreicht, daß heißt der Strom durch ihn wird verringert. Dadurch bedingt ergibt sich wiederum eine erhöhte Dain-Source Spannung, wodurch der zweite Halbleiterschalter 3 einen erhöhten Strom liefert. Zum Zeitpunkt t₅ ist der erste Halbleiterschalter 2 vollständig abgeschalten, während der zweite Halbleiterschalter 3 bis zum erreichen seiner Einsatzspannung zum Zeitpunkt t₆ noch einen großen Strom liefert. Hierdurch wird auch während der Abschaltflanke eine Verrundung des Stromverlaufs hervorgerufen.

Durch die Erfindung ist es folglich auf einfache Weise möglich, die elektromagnetische Abstrahlung stark zu reduzieren, da diese ausschließlich durch den Verlauf der Flanken beim Übergang in den leitenden beziehungsweise beim Übergang in den nichtleitenden Übergang Zustand hervorgerufen wird. Da auf eine teure und aufwendige Steuerung zur Flankenformung verzichtet werden kann, kann die erfindungsgemäße Schaltungsanordnung sehr einfach realisiert werden. Die Erfindung eignet sich insbesondere für den Einsatz in Kraftfahrzeugen, da dort die elektromagnetische Verträglichkeit der verschiedenen elektrischen Komponenten eine große Rolle spielt. Die Schaltungsanordnung eignet sich gleichermaßen für Versorgungsspannungen von 12 Volt bis 42 Volt, wie diese im Kraftfahrzeug eingesetzt werden. Es ist jedoch auch denkbar, Versorgungsspannungen von 220 Volt oder 380 Volt, zum Beispiel bei diskreten Schaltern in einem Dreiphasennetz vorzusehen.

In den vorliegenden Ausführungsbeispielen nach Figur 1 oder Figur 3 ist jeweils nur eine Schaltvorrichtung dargestellt. Selbstverständlich ist es auch denkbar eine Halbbrücke, eine Vollbrücke oder aber eine Dreiphasen-Brücke vorzusehen, bei der jede Schaltvorrichtung einen ersten und mindestens einen zweiten Halbleiterschalter aufweist, um die elektromagnetische Abstrahlung zu verringern. Die Erfindung weist zu dem den Vorteil auf, daß der Anstieg bzw. Abfall der Stromflanken des ersten Halbleiterschalters, daß heißt eigentlichen Leistungs-Halbleiterschalters, sehr steil ausgeführt werden kann, daß die Schaltverluste gering bleiben.

Die Schaltvorrichtung könnte auch aus mehr als zwei parallel geschalteten Halbleiterschaler bestehen. In diesem Fall wären dann die Einsatzspannungen sowie die Zellenanzahl bzw. W/L Verhält-nisse unterschiedlich. Je größer die Anzahl der parallel geschalteten Halbleiterschalter ist, desto gezielter kann die Flankenform des Stromverlaufes beeinflußt werden.

Figur 3 zeigt ein weiteres Ausführungsbeispiel der Erfindung, wobei dort eine Low-side- Konfiguration dargestellt ist. Dies bedeutet die Last 1 ist mit einem hohen Versorgungspotential V_{bb} an einem ersten Versorgungspotentialanschluß 4 verbunden. Zwischen dem anderen Anschluß der Last 1 und dem zweiten Versorgungspotentialanschluß 5, an dem ein niedriges Bezugspotential anliegt, ist die Schaltvorrichtung 7 vorgesehen, die wie in Figur 1 beschrieben, aufgebaut ist.

## Patentansprüche

1. Schaltungsanordnung zum Ansteuern einer Last (1) mit reduzierter Störabstrahlung
mit einer Schaltvorrichtung (7), die seriell mit der Last (1) zwischen zwei versorgungspotentialanschlüsse (4,5) geschaltet ist,
und mit einer Steuervorrichtung, die die Schaltvorrichtung (7) leitend oder sperrend ansteuert und die
einen ersten und mindestens einen zweiten Halbleiterschalter (2, 3) aufweist, die als feldeffektgesteuerte Bauelemente realisiert sind, deren Laststrecken parallel geschaltet sind, die Steueranschlüsse (2c, 3c) aufweisen, die miteinander verbunden sind, und die jeweils eine Anzahl Zellen aufweisen wobei die Einsatzspannung des ersten Halbleiterschalters (2) größer als die des zweiten Halbleiterschalters (3) ist und wobei der erste Halbleiterschalter (2) eine größere Zellenanzahl als der zweite Halbleiterschalter (3) aufweist.

2. Schaltungsanordnung nach Patentanspruch 1,
**dadurch gekennzeichnet, dass**
die Zellenanzahl des zweiten Halbleiterschalter (3) zwischen 2 und 5 % des ersten Halbleiterschalters (2) beträgt.

3. Schaltungsanordnung nach einem der Patentansprüche 1 oder 2,
**dadurch gekennzeichnet, dass**
die Schaltungsanordnung monolithisch integriert oder diskret aufgebaut ist.

## Claims

1. Circuit arrangement for controlling a load (1) with reduced interference emission,
having a switching apparatus (7) which is connected in series with the load (1) between two supply potential connections (4, 5) ,
and having a control apparatus which turns the switching apparatus (7) on or off, said switching apparatus having
a first semiconductor switch (2) and at least one second semiconductor switch (3) which are in the form of field-effect-controlled components whose load paths are connected in parallel, which have control connections (2c, 3c) that are connected to one another and which each have a number of cells, the threshold voltage of the first semiconductor switch (2) being greater than that of the second semiconductor switch (3), and the first semiconductor switch (2) having a greater number of cells than the second semiconductor switch (3).

2. Circuit arrangement according to Patent Claim 1,
**characterized in that**
the number of cells in the second semiconductor switch (3) is between 2 and 5% of that in the first semiconductor switch (2).

3. Circuit arrangement according to either of Patent Claims 1 and 2,
**characterized in that**
the circuit arrangement is monolithically integrated or constructed in discrete fashion.

## Revendications

1. Montage de commande d'une charge (1) en ayant un rayonnement parasite réduit
comprenant un dispositif (7) de commutation, qui est monté en série avec la charge (1) entre deux bornes (4, 5) de potentiel d'alimentation
et comprenant un dispositif de commande, qui commande le dispositif (7) de commutation de manière à ce qu'il soit passant ou bloqué et qui
a un premier et au moins un deuxième commutateurs (2, 3) à semi-conducteurs, qui sont réalisés en composants commandés par effet de champ, dont les sections de charge sont montées en parallèle, qui ont des bornes (2c, 3c) de commande reliées entre elles et qui ont respectivement un nombre de cellules, la tension de seuil du premier commutateur (2) à semi-conducteurs étant plus haute que celle du deuxième commutateur (3) à semi-conducteurs et dans lequel le premier commutateur (2) à semi-conducteurs a un nombre de cellules plus grand que le deuxième commutateur (3) à semi-conducteurs.

2. Montage suivant la revendication 1,
**caractérisé en ce que**
le nombre de cellules du deuxième commutateur (3) à semiconducteur, représente entre 2 et 5 % de celui du premier commutateur (2) à semi-conducteurs.

3. Montage suivant l'une des revendications 1 ou 2,
**caractérisé en ce que**
le montage est intégré monolithiquement ou est constitué de manière discrète.
